# EUROPEAN PATENT APPLICATION

(11) **EP 2 734 022 A2**
(43) Date of publication of application: **21.05.2014**
(21) Application number: 13193424.2
(22) Date of filing: 19.11.2013
(51) Int. Cl.: H05K 7/20

(54) **Cooling system**

(30) Priority: 19.11.2012 US 201261727986 P; 18.11.2013 US 201314083052
(71) Applicant: Solidstate Controls, LLC, Colombus, OH 43085 (US)
(72) Inventor: Nienberg, Kurt, Columbus, OH 43085 (US); Irwin, Philip, Columbus, OH 43085 (US)
(74) Representative: Dennemeyer & Associates S.A.

(57) **Abstract**

A cooling system having a source of pressurized intake air includes a primary fan and a secondary fan spaced apart from the primary fan. The pressurized intake air flows from either of the primary or secondary fans. Ductwork includes an inlet, at least one generally hollow supply plenum in fluid communication with the inlet, and at least one supply opening in fluid communication with the supply plenum. The pressurized intake air is urged into the inlet, through the supply plenum and out of the supply opening as a first air supply. The supply opening is configured to direct the first air supply toward at least one first heat generator. The secondary fan is configured to operate in a predetermined manner corresponding to a status of the primary fan.

## Description

### Cross-Reference to Related Applications

This application claims priority to U.S. provisional application 61/727,986, filed November 19, 2012, the entire contents of which are hereby incorporated by reference.

### Field

The present invention relates generally to cooling systems, in particular to cooling systems employing pressurized, impinging airflow to cool heat-generating objects such as electronic components.

### Background

An uninterruptible power supply (UPS) is an electrical apparatus that provides emergency power to a load when the input power source, typically mains power, fails. A UPS is typically used to protect loads such as computers, data centers, telecommunication equipment, or other electrical equipment where an unexpected power disruption could cause injuries, fatalities, serious business disruption, or data loss. A UPS typically utilizes solid-state power electronics to convert a direct current (DC) power source (typically a battery or batteries) to an alternating-current (AC) voltage having a frequency and amplitude suitable for powering the load. The electronic components of a UPS system are typically housed within a cabinet, and these components normally generate heat during operation. Although power electronics technology has taken significant steps in the advancement of semiconductor design in recent years, thermal management of the power electronics remains a key element to achieving the requisite UPS system reliability. Thus, the electronic components require cooling to maintain crucial functionality of the system. Further, UPS systems typically require redundancy in the cooling system to provide a backup to maintain the cooling system in case a primary component fails.

UPS cooling systems are typically non-ducted, air-cooled arrangements and cool the heat-generating power electronics in one of several ways. In a first approach, a fan is utilized to move cooling air through an entire cabinet that houses the UPS components. Typically, one or more exhaust fans are mounted in the top or rear of the cabinet housing and draw air across the UPS components. The cooling air is pulled in from the surrounding room environment through one or more intake grilles mounted on the opposite side of the cabinet, such as the lower front of the housing. Typically, some UPS components are coupled to heat sinks to provide a larger surface area for more efficient heat rejection. Alternatively, a UPS cooling system may be configured to move air over targeted individual components and subassemblies with multiple supply or exhaust fans mounted adjacent to the components. In yet other UPS cooling systems, liquid cooling is utilized with a heat transfer fluid. However, each of these systems suffers from drawbacks, such as relatively high cost, complexity, and insufficient reliability or redundancy.

Due to the aforementioned criticality of UPS systems a plurality of fans are often utilized to cool UPS components. This does not necessarily create complete redundancy of the cooling system; however, it does increase the cost of the cooling system. Furthermore, the cost of cooling fans generally increases as fans increase in their rated cubic feet per minute (CFM) air-moving capacity. Draw-through, non-ducted cooling systems require higher airflow rates than blow-through, ducted systems in order to remove heat generated by the UPS components. Consequently, a plurality of lower-rated CFM fans are often utilized in draw-through, non-ducted cooling systems to reduce cost. However, as UPS systems and their heat sink requirements become greater, the number of the lower-rated CFM fans required to cool the UPS increases. In general, the larger the power-delivery capacity the UPS system has, the greater the number of fans that are needed, thus adding to system costs. The critical nature of UPS cooling systems further necessitates employing more sophisticated controls to ensure seamless activation of backup equipment used for redundancy. These controls may include adding sensing means for detecting fan failures, and these control systems act to further increase costs for the cooling system. A need remains for a UPS cooling system that uses a pressurized blow-through ducted airflow system with relatively simple controls to directly air-cool heat-generating components.

### Summary

A cooling system is disclosed according to an embodiment of the present invention. The present invention is a pressurized ducted fan system configured to minimize the number of fans, wiring and alarm peripherals required to reliably cool heat generators such as UPS power switching components. Preferably, a primary fan and a secondary backup fan are utilized, the fans having a relatively large air-moving capacity to maximize airflow supplied to the heat generators for cooling.

The disclosed invention is scalable and thus may be economically and reliably used in connection with UPS systems having a range of load capacities. Common components may be utilized for cooling systems of UPS systems with various load capacities, thereby driving up volume production in order to reduce component costs while reducing inventory requirements. The use of common components may reduce field service labor and expense, as well.

In one embodiment of the invention a cooling system is disclosed. A source of pressurized intake air includes a primary fan and a secondary fan spaced apart from the primary fan. The pressurized intake air flows from either of the primary or secondary fans. Ductwork includes an inlet, at least one generally hollow supply plenum in fluid communication with the inlet, and at least one supply opening in fluid communication with the supply plenum. The pressurized intake air is urged into the inlet, through the supply plenum and out of the supply opening as a first air supply. The supply opening is configured to direct the first air supply toward at least one first heat generator. A cabinet is configured to house the source of pressurized intake air, the ductwork, and the first heat generator. The secondary fan is configured to operate in a predetermined manner corresponding to a status of the primary fan.

In another embodiment of the invention a cooling system is disclosed. A source of pressurized intake air includes a primary fan and a secondary fan spaced apart from the primary fan. The pressurized intake air flows from either of the primary or secondary fans. A pressure zone is between the primary fan and the secondary fan. Ductwork includes an inlet, at least one generally hollow supply plenum in fluid communication with the inlet, and at least one supply opening in fluid communication with the supply plenum. The pressurized intake air is urged into the inlet, through the supply plenum and out of the supply opening as a first air supply. The supply opening is configured to direct the first air supply toward at least one first heat generator. The secondary fan is configured to operate in a predetermined manner corresponding to the status of the pressure zone.

### Brief Description of the Drawings

Further features of the inventive embodiments will become apparent to those skilled in the art to which the embodiments relate from reading the specification and claims with reference to the accompanying drawings, in which:
Fig. 1 shows the general arrangement of a cooling system for heat-generating components according to an embodiment of the present invention;
Fig. 2 shows a schematic diagram of air flow through the rear of a heat sink of Fig. 1 indicating the path of air flow through the heat sink;
Fig. 3 shows the general arrangement of a cooling system according to another embodiment of the present invention;
Fig. 4 is a partial cutaway view of a cabinet or enclosure, showing the general arrangement of a cooling system according to another embodiment of the present invention;
Fig. 5 is a schematic block diagram of a fan control portion of a cooling system according to an embodiment of the present invention;
Fig. 6 shows the general arrangement of a cooling system according to still another embodiment of the present invention;
Fig. 7 shows the general arrangement of a ductwork portion of a cooling system according to yet another embodiment of the present invention;
Fig. 8 is a close-up view of portions of the cooling system of Fig. 7;
Fig. 9 is another view of the cooling system of Fig. 7;
Fig. 10 shows the ductwork of Fig. 7 with heat-generating components coupled thereto;
Fig. 11 shows a side section view of the cooling system of Fig. 10; and
Fig. 12 shows the scalable capability of the cooling system of Fig. 7.

### Detailed Description

In the discussion that follows, like reference numerals are used to refer to like elements and structures in the various figures.

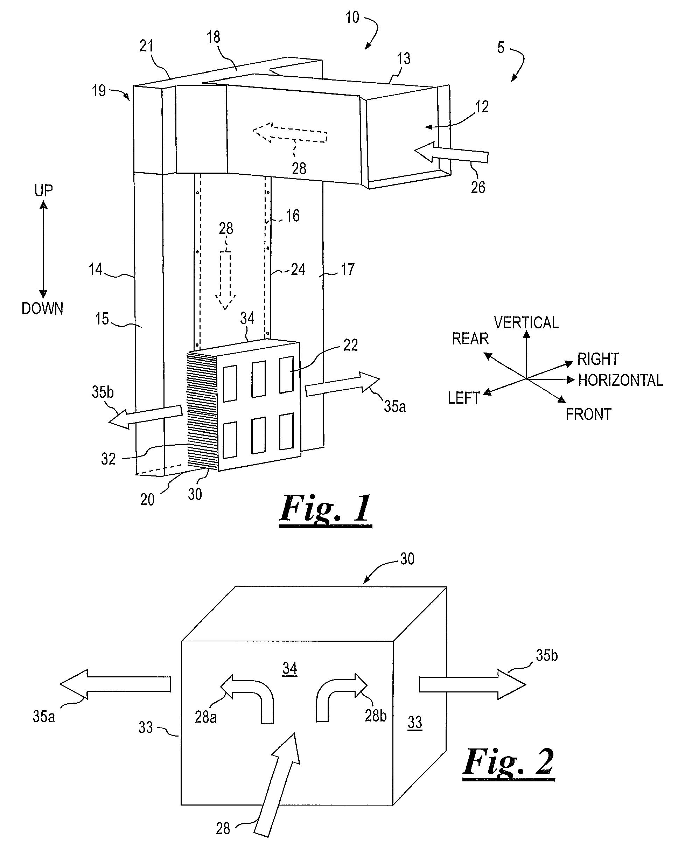

The general arrangement of a cooling system 5 having a ductwork 10 is shown in Fig. 1 according to an embodiment of the present invention. Ductwork 10 includes an inlet 12, a generally hollow supply plenum 14, and a first supply opening 16. First supply opening 16 is in fluid communication with the supply plenum 14 and is generally laterally centered about a front wall 17 of the supply plenum. Inlet 12 is in fluid communication with the supply plenum 14 and may include an inlet supply duct 13 connected to an upper portion 19 of the supply plenum. Supply plenum 14 may be generally rectangular in shape and includes a pair of opposing sidewalls 15, the front wall 17, a top 18, a base 20, and a rear wall 21. The base 20 encloses the lower portion of the supply plenum and is connected generally orthogonally to the front wall 17 and to the rear wall 21. In some embodiments, base 20 may additionally serve as structural support for ductwork 10 and/or for mounting equipment or electronic components served by the ductwork.

Ductwork 10 is shown adjacent to one or more first electronic components or other heat-generating devices, objects or elements 22 (generally termed "heat generators" herein), such as power-switching components of a UPS. The heat generators 22 are mounted adjacent to supply plenum 14 and to first supply opening 16 so the heat generators may be cooled by ducted airflow. A cover 24 may be detachably, selectably or permanently coupled to plenum 14 to close off any unused exposed portions of first supply opening 16.

Cooling system 5 for heat generators 22 includes a source of pressurized intake air 26 and the ductwork 10. In operation of ductwork 10, pressurized cooling intake air 26 is provided to or urged into inlet 12 (or generated within inlet supply duct 13 as detailed further below), forming a first air supply 28. First air supply 28 is urged through the supply plenum 14 and out of the first supply opening 16. The first supply opening 16 is configured to direct the first air supply 28 toward at least one first heat generator 22. Alternatively, the first air supply 28 may be directed toward a plurality of first heat generators 22.

In one embodiment heat generators 22 include heat sinks 30 adapted to transfer heat away from heat generators such as electronic power converters and inverters. First supply opening 16 may be used to supply airflow to one or more heat sinks 30, which may be vertically stacked adjacent to the front wall 17 of plenum 14, and each heat sink generally covering a portion of first supply opening 16. Heat sink 30 may be configured as a module that includes a plurality of heat generators 22 coupled thereto. Heat sink 30 may include a plurality of spaced-apart and generally horizontally parallel fins 32 configured to dissipate heat generated by the heat generators 22 through heat transfer to air flowing across and around the fins.

Referring to Figs. 1 and 2, the heat sink 30 is configured to receive the first air supply 28, the first air supply being bifurcated into a first portion 28a and a second portion 28b, the first portion and second portion being discharged from opposing sides 33 of the heat sink. Airflow from first air supply 28 is urged centrally through an intake 34 of one or more heat sinks 30 of heat generators 22, impinges the interior of the heat sink, divides generally equally to either side, and exits generally laterally out the sides 33 of the heat generators as exhaust air 35a, 35b. The exhaust air 35a, 35b exiting from heat sinks 30 may then flow generally upwardly through a not-shown cabinet, exiting from a top portion of the cabinet through vents (not shown), which may be positioned on either or both sides of the inlet duct 13.

The above-described air flow through heat sinks 30 is termed "impinging flow" herein and is one of the most efficient ways to cool a heat sink. It relies on two basic principles. First, impinging flow creates a turbulent air flow profile. Turbulence from an air flow standpoint increases the heat transfer rate from the heat sink 30 to the air stream. This increased heat transfer permits a reduction in the amount of heat sink material necessary in the design and, accordingly, reduces cost. Secondly, the amount of heat an air stream can absorb is directly proportional to the temperature differential of the heat sink 30 to the air stream. Since the air heats up as it absorbs heat from the fins 32 of the heat sink 30 as it travels through the heat sink it cannot absorb as much heat downstream. This typically requires a longer heat sink 30 and more surface area to transfer the heat to the air. By using impinging flow, the air enters the intake 34 at the rear of the heat sink, is split roughly at the center at entry and then exhausts in opposing directions, exiting generally laterally from each side 33. Accordingly, the temperature rise of the air is not as significant and the air flowing through the devices being cooled is at a lower temperature, allowing the air to absorb more heat. This provides two favorable results. Firstly, a shorter and lower mass heat sink 30 is needed which equates to better module economics / efficient material usage and lower static pressure drop due to the smaller heat sink. Additionally, since the air is split, the velocity decreases, thereby contributing to lower static pressure drop.

Lower static pressure drop is important, as the more static pressure is required the higher the power required by the fans. Typical flow curves for any fan demonstrate that, as static pressure goes up, the air volume in cubic feet per minute produced by the fan goes down. It is desirable to reduce the number of fans needed while optimizing cooling efficiency. Stated another way, it is desirable to reduce the total amount of air volume needed while still achieving the required cooling characteristics. In general, the higher the amount of CFM of air flow and the higher the static pressure needed, the larger (and, potentially, more expensive) the fan must be. Cooling system 5, utilizing impinging air flow through heat sinks 30, reduces the cost of the fans providing the pressurized intake air.

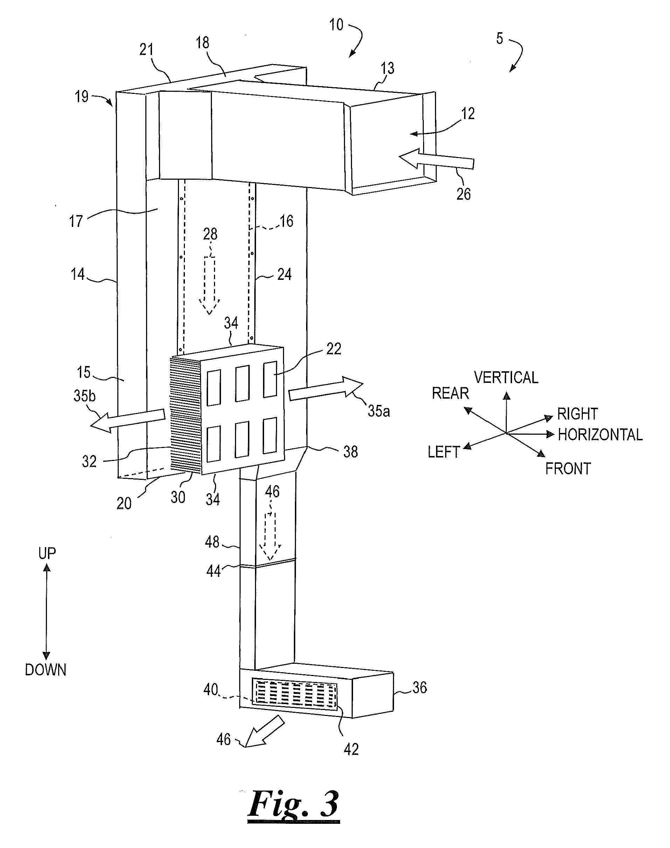

With reference now to Fig. 3, in some embodiments of the present invention ductwork 10 may further include a generally hollow auxiliary plenum 36 coupled to a lower portion 38 of supply plenum 14 by a generally hollow extension duct 48. Alternatively, extension duct 48 may connect to any portion of supply plenum 14. Auxiliary plenum 36 includes a second supply opening 40 and, optionally, one or more supply grilles or grates 42. Supply grille 42 may be configured to direct air from second supply opening 40 toward at least one second heat generator, such as a not-shown transformer (or transformers) of a UPS, and may further be adapted to control or limit the volume of air exiting from second supply opening 40. For example, grille 42 may be a supply register that includes an air damper (not shown) to balance the air flow from second supply opening 40, and/or may include surface louvers (not shown) to control the direction of the air supplied. In some embodiments of the present invention a duct-mounted damper 44 may be placed in extension duct 48 to selectably control or limit the volume of air flowing through the extension duct and, ultimately, second supply opening 40.

In operation of the embodiment of Fig. 3, a portion of the first air supply 28 described above is provided to auxiliary plenum 36 via extension duct 48, forming a second air supply 46. A portion of second air supply 46 may exit second supply opening 40 and, optionally, may be directed toward at least one second heat generator 22 (not shown) by supply grille 42. Alternatively, the second air supply 46 may be directed toward a plurality of second heat generators. In alternate embodiments second supply opening 40 may be partially or completely closed off as desired to control the volume of air flow from the second supply opening.

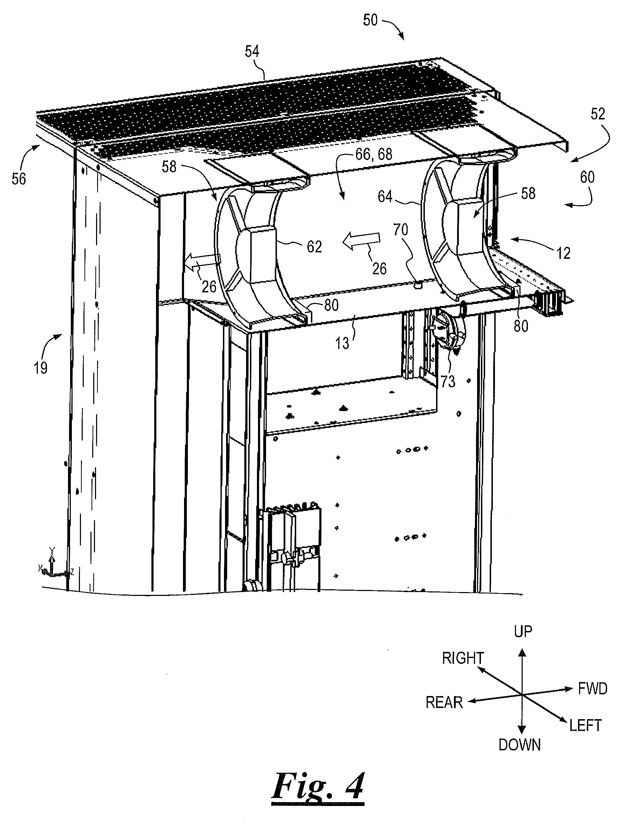

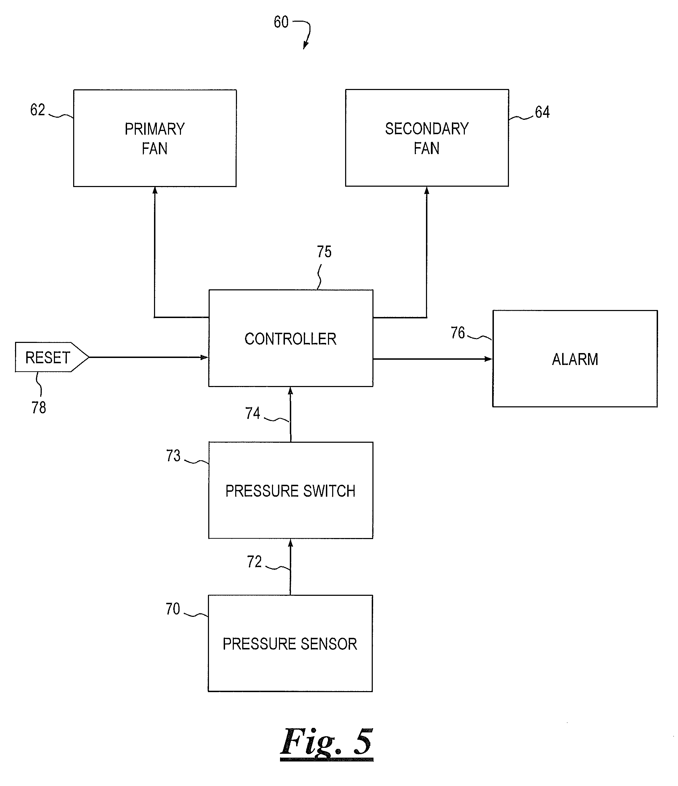

A cooling system 50 with an air supply system 60 configured as a source of pressurized cooling intake air 26 in inlet 12 of ductwork 52 is shown in Figs. 4 and 5 according to an embodiment of the present invention. Cooling system 50 includes an enclosure or cabinet 54, the source of pressurized intake air or air supply system 60, and ductwork 52. Air supply system 60 includes a primary fan 62 and a secondary fan 64 spaced-apart from the primary fan by an intake chamber 66. A pressure zone 68 is formed in the intake chamber 66 between primary fan 62 and secondary fan 64. A pressure sensor 70 is in communication with the pressure zone 68 and monitors the air pressure level in the pressure zone to generate a corresponding electrical pressure signal 72. Alternatively, a plurality of pressure sensors 70 may be used to sense air pressure in ductwork 52. The pressure sensor 70 is configured to sense a positive pressure level, a neutral pressure level, and a negative pressure level within the pressure zone, the positive, neutral and negative pressure levels each indicating a predetermined status of the pressure zone 68. The pressure sensor 70 being further adapted to transmit a pressure signal to a pressure switch 73 corresponding to the status of the pressure zone 68.

In one embodiment one or more static pressure switches 73 may be coupled to the pressure sensor. This type of pressure switch 73 is generally less expensive than typical Hall Effect sensors, which may alternatively be utilized for this purpose. Additionally, only one sensor for pressure zone 68 is needed, versus one per fan, thereby providing for cooling system simplification and cost reduction. In operation of pressure switch 73, at any point where the negative static pressure in pressure zone 68 drops due to failure of the primary fan 62, the pressure switch will change its electrical state or "trip." The pressure switch 73 is configured to convert the pressure signal 72 to a corresponding status signal 74. The status signal 74 indicating the status of the pressure zone 68 as either a normal mode or primary fan failure mode. The pressure switch 73 is coupled to a controller 75 and configured to transmit the status signal 74 to the controller. The controller 75 is configured to receive and process the status signal 74 from the pressure switch 73 and control the operation of the secondary fan 64 in a predetermined manner. Alternatively, the pressure sensor 70 may be configured to generate an electrical signal corresponding to the pressure level and transmit the signal directly to the controller 75 for further processing.

In the embodiment of Fig. 4 primary fan 62 is located in a rear portion of intake chamber 66 adjacent to the upper portion 19 of supply plenum 14. Primary fan 62 is configured to operate generally continuously after initial startup. Secondary fan 64 is located further forward in intake chamber 66 adjacent to the inlet 12. During normal operation of primary fan 62, secondary fan 64 freewheels under a pressure drop in pressure zone 68, and a vacuum (also referred to as negative pressure herein) is created in intake chamber 66 due to a positive pressure generated at the discharge of primary fan 62. In operation, during a predetermined startup time of air supply 60 there is initially no power to secondary fan 64. Pressure sensor 70 samples the pressure in pressure zone 68. During startup, primary fan 62 begins to generate negative pressure in pressure zone 68. Pressure signal 72, representing the status of the pressure zone, is supplied to the pressure switch 73.

In one embodiment, the pressure switch is configured to be either "open" or "closed" in accordance with a pressure signal 72 from pressure sensor 70. Upon receiving a pressure signal 72 indicating a predetermined level of negative pressure, the pressure switch 73 is in an "open" condition and transmits a status signal 74 to the controller 75 indicating "normal mode". Upon receiving a pressure signal 72 indicating a predetermined level of neutral pressure (i.e., little or no negative pressure), the pressure switch 73 is in a "closed" condition and transmits a status signal 74 to the controller 75 indicating "primary fan failure mode". Additionally, upon receiving a pressure signal 72 indicating a predetermined level of positive pressure, the pressure switch 73 is in or remains in the "closed" condition and transmits a status signal 74 to the controller 75 indicating "primary fan failure mode". One skilled in the art will recognize that inverse "open" and "closed" switch logic may be employed within the scope of the invention.

As primary fan 62 first begins acceleration to running speed, the pressure sensor will transmit a low negative pressure that closes the pressure switch 73 and transmits a status signal 74 to the controller 75 indicating "primary fan failure mode". However, controller 75 is aware of the startup mode status of the primary fan 62 and will ignore the status signal 74 for a predetermined amount of time to allow a predetermined level of negative pressure in intake chamber 68 to be attained for normal primary fan operating conditions.

After the predetermined startup time has elapsed, in the event that primary fan 62 fails, the negative pressure level in pressure zone 68 is reduced (i.e., becomes less negative, or closer to neutral pressure). Pressure sensor 70 generates a pressure signal 72 corresponding to the drop in negative pressure to the pressure switch 73. The pressure switch 73 may then "close" and transmit a status signal 74 to the controller 75 indicating "primary fan failure mode". Controller 75 receives the status signal 74, and activates secondary fan 64 by directly or indirectly causing electrical power to be supplied to the secondary fan. Controller 75 may also activate an aural and/or visually perceivable alarm 76 (which may be local or remote) indicating a failure of primary fan 62.

Once secondary fan 64 is activated, the secondary fan will generate a positive air pressure in pressure zone 68. This positive air pressure causes pressure sensor 70 to generate a corresponding pressure signal 72 indicating the increase in pressure. Pressure switch 73 receives pressure signal 72, remains "closed", and continues to transmit a status signal 74 to the controller 75 indicating "primary fan failure mode". Controller 75 detects the pressurization of pressure zone 68, and correspondingly maintains alarm 76 in an active state to indicate the failure of primary fan 62.

Stated more generally, one skilled in the art will appreciate that the aforementioned pressure states of pressure zone 68 (i.e., negative pressure, neutral pressure, positive pressure) may be sensed by controller 75 to determine the operational status of either or both of fans 62, 64. Controller 75 may accordingly control the operation of either of both of fans 62, 64 in any suitable predetermined manner based upon the pressure state of pressure zone 68. Controller 75 may likewise issue an alarm or system status signal (or signals) based upon the pressure state of pressure zone 68.

In some embodiments alarm 76 and secondary fan 64 are configured to remain in an active state until primary fan 62 is replaced or otherwise made operational and an appropriate fan reset signal 78 is supplied to controller 75. An operator of the cooling system 50 may then repair or replace primary fan 62 and then activate the reset signal 78. The reset signal 78 may be transmitted by any suitable device, such as a push button or toggle switch. The fan reset signal 78 instructs controller 75 to deactivate alarm 76 and secondary fan 64 and again monitor for subsequent faults in primary 62 as described above. Preferably, controller 75 is powered by a plurality of independent power sources so that, no matter what portions of the UPS are operational, the fans 62, 64 will maintain power. In some embodiments, the cooling system 50 may include redundant controls, such as a secondary pressure switch, controller, or alarms.

In some embodiments of the present invention fans 62, 64 may be configured with one or more "hot swap" power and interface connectors 80 (Fig. 4), allowing "live" electrical connections to the fans to be made between the fans and the cooling system when the fans are physically installed into intake chamber 66, rather than first disconnecting electrical power. Additionally, the interface connectors 80 allow the "live" electrical connections to be disconnected when the fans 62, 64 are removed from the intake chamber. This configuration, with the fans preferably located at an upper portion 56 of cabinet 54, provides for ease of field service in the event replacement of a fan is required. Fans 62, 64 may further be mounted in or configured as replaceable modules or cartridges 58 including hot-swappable connectors 80 that are selectably removable from the system to facilitate rapid change-out. To replace a fan a few securing screws (not shown) are removed and the entire fan cartridge 58 is slid generally upwardly, disconnecting the electrical power at connector 80 and separating the fan cartridges from the cabinet 54. As noted above, this may be accomplished without powering down the electrical equipment or cooling system. Once a new fan cartridge is slid into place and secured, reset signal 78 is provided to control 74 to deactivate alarm 76 and secondary fan 64. The UPS will thereafter operate under its normal mode operating conditions.

In other embodiments, the status of the primary fan 62 may be determined in addition or alternatively by any other suitable devices such as temperature sensors within cabinet 54 or current sensors for the fan. In another embodiment, the primary fan 62 is adjacent and in parallel configuration with the secondary fan 64. In a further embodiment, one of the fans may be located remote from the cabinet 54, such as above a ceiling, and the supply ducted to the inlet 12.

In still other embodiments a visually and/or aurally perceivable, local and/or remote alarm may optionally be directly coupled to any of the aforementioned arrangements for determining the status of primary fan 62, and generate an alarm output if a failure of the primary fan is detected.

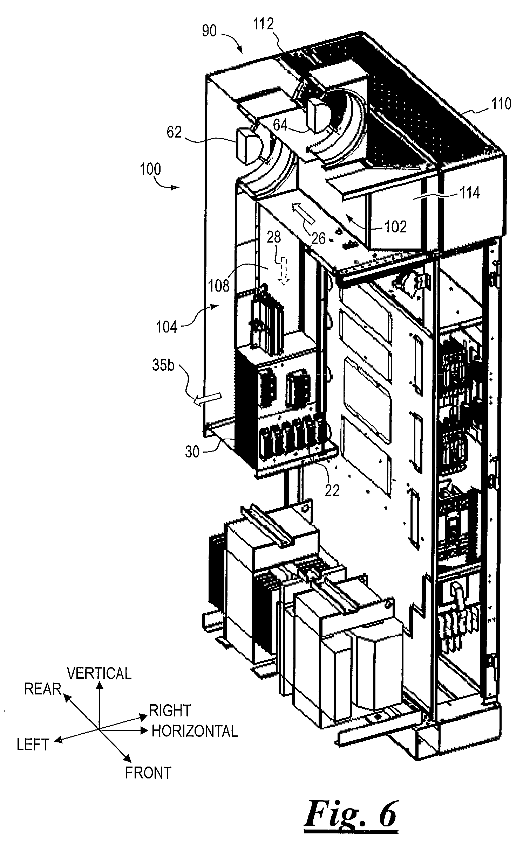

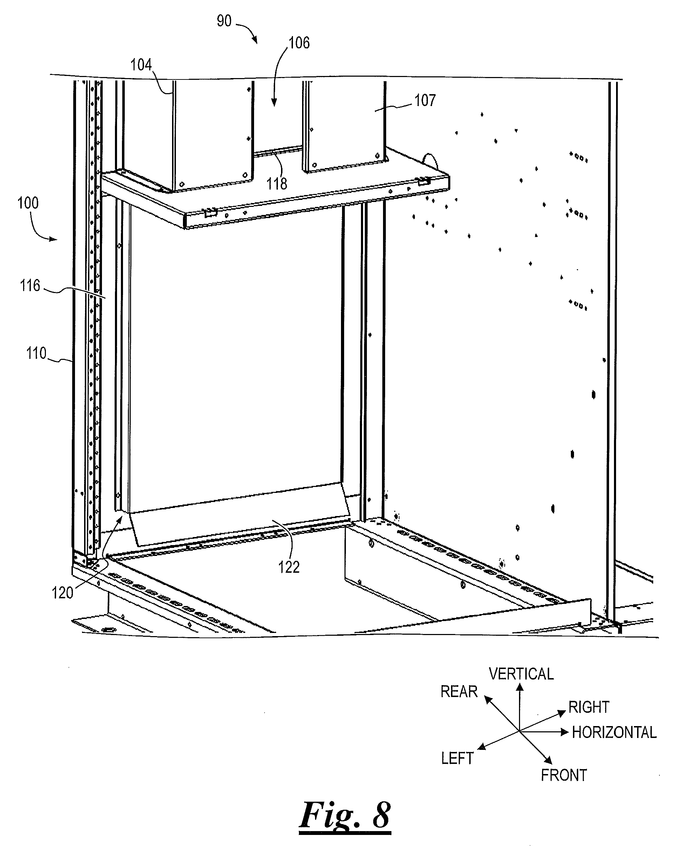

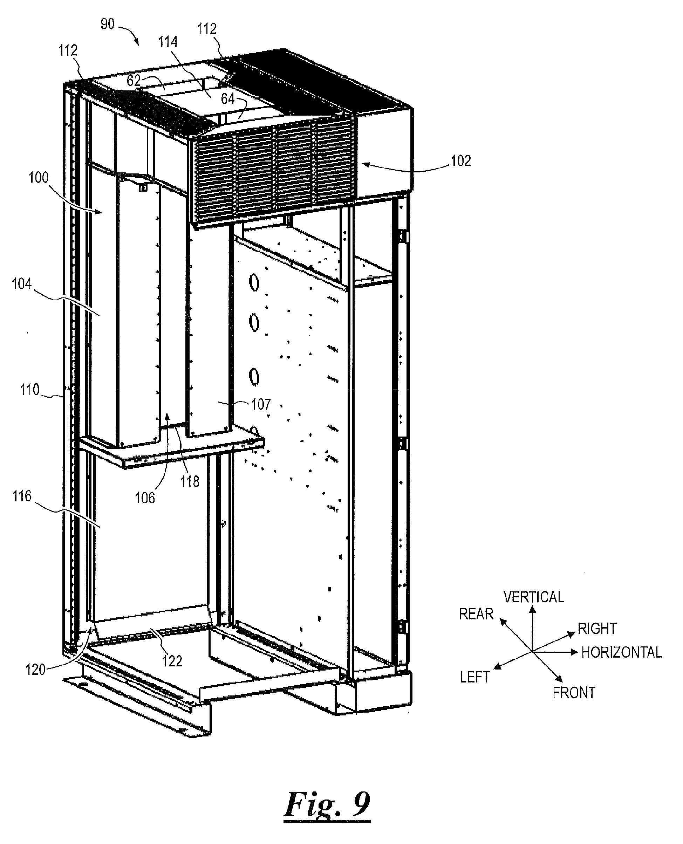

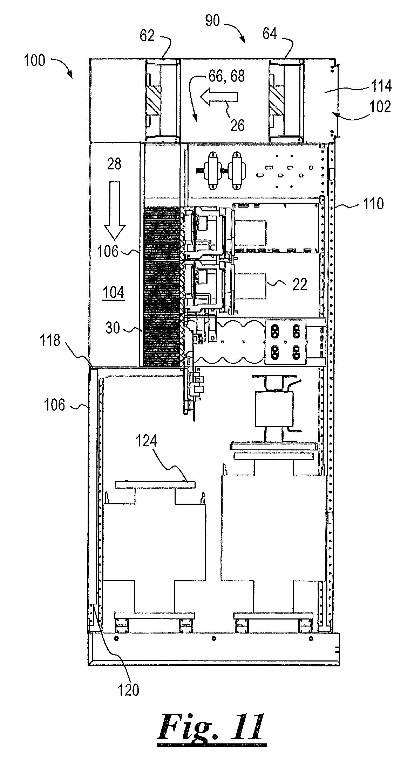

The general arrangement of a cooling system 90 having a ductwork 100 is shown in Figs. 6 through 11 according to another embodiment of the present invention. Ductwork 100 includes an inlet 102, a generally hollow plenum 104, and a first supply opening 106. First supply opening 106 maybe generally laterally centered about a sidewall 107 of plenum 104.

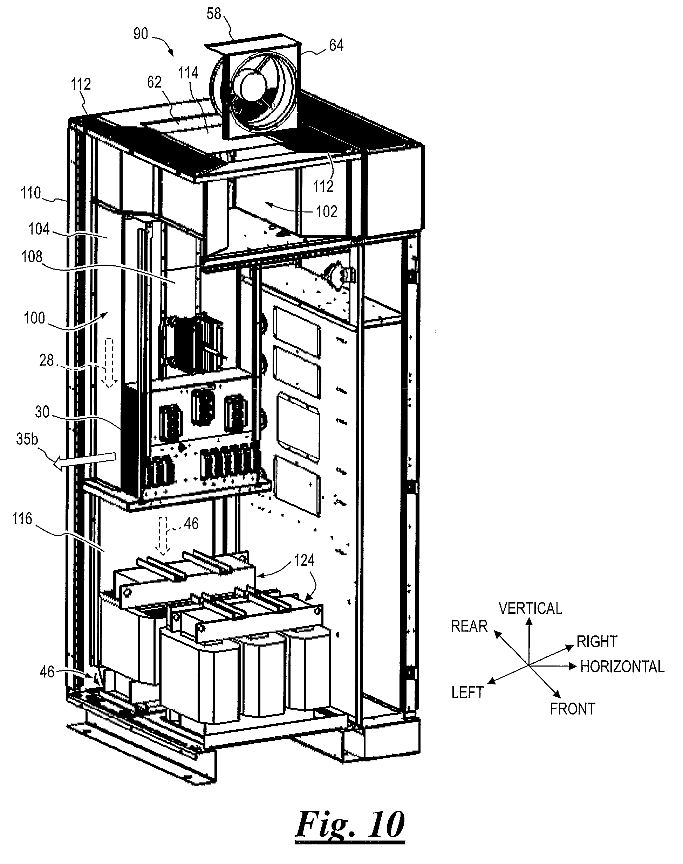

Ductwork 100 is shown in the partial cut-away view of Fig. 10 with heat generators 22, such as power-switching components of a UPS, attached to plenum 104 and generally covering a portion of first supply opening 106. A cover 108 may be coupled to plenum 104 to selectably close off any remaining exposed portions of first supply opening 106.

In operation of ductwork 100, pressurized cooling intake air 26 is provided to (or generated within) inlet 102, forming a first air supply 28. First air supply 28 is urged through first supply opening 106, impinging upon heat sinks 30 of heat generators 22. In one embodiment first air supply 28 is urged through one or more heat sinks 30 of heat generators 22, exiting generally laterally out the sides 33 of the heat sinks as exhaust air 35. The exhaust air 35 exiting from heat sinks 30 may then flow generally upwardly through a cabinet 110, exiting from a top portion of the cabinet via generally horizontally-oriented vents 112 positioned in the top portion on either side of an inlet duct 114. Inlet 102 of inlet duct 114 may include a grille or louver covering the opening in the cabinet 110.

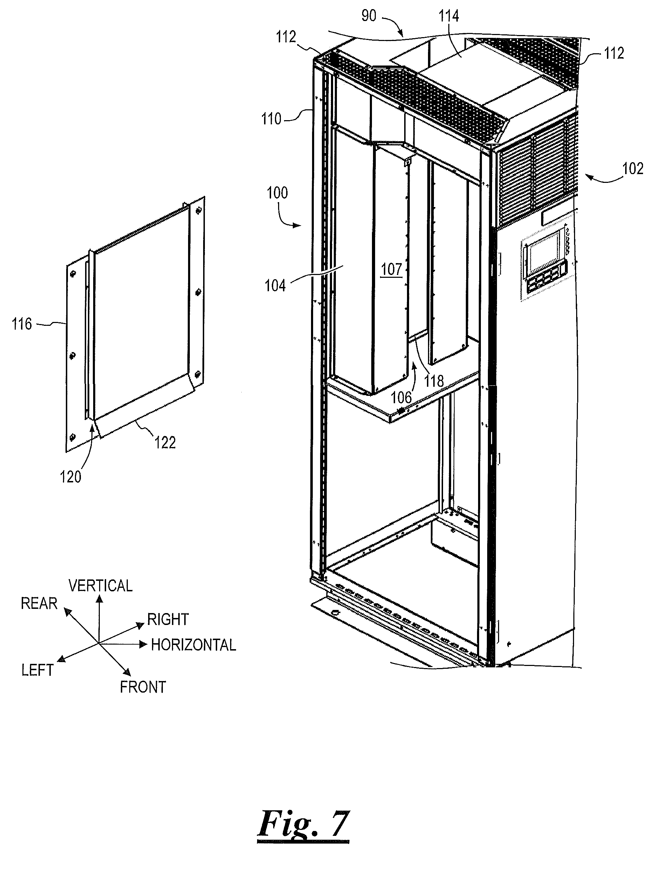

With reference now to Figs. 7 through 11 together, in some embodiments of the present invention ductwork 100 may further include a generally hollow auxiliary plenum 116 coupled to plenum 104 and configured to receive a portion of first air supply 28 through a lower opening 118 in plenum 104. Auxiliary plenum 116 includes a second supply opening 120 and, optionally, one or more deflectors, louvers or grates 122. Grates 122 may be configured to direct air from second supply opening 120 toward second heat generators 124, such as a transformer (or transformers) of a UPS, and may further be adapted to control the volume of air exiting from second supply opening 120.

In operation of the embodiment of Figs. 6 through 11, a portion of the first air supply 28 described above is provided to auxiliary plenum 116, forming a second air supply 46. A portion of second air supply 46 may exit second supply opening 120 and, optionally, may be directed toward second heat generators 124 by louver or grate 122. In alternate embodiments of the present invention second supply opening 120 may be partially or completely closed off as desired, to control the volume of air flow from the second supply opening.

The above-described elements of ductworks 10, 52, 100 may be made from any suitable materials including, without limitation, metal, fiberglass, plastic and composite materials. In addition, the elements may be made using any suitable process such as, without limitation, extrusion, forming, casting, machining and forging. Ductwork may be formed by suitable standards, such as joined along elongate edges by interlocking flanges, or adjoining flanges fastened with sheet metal screws, clamps or adhesives. Furthermore, the elements may be finished using one or more of paint, dyes and coatings, or may be left unfinished. Ductwork or cabinet members may include noise attenuation through exterior insulation or interior lining.

With general reference to Figs. 1 through 11 together, in some embodiments ductworks 10, 52, 100 may be made from sheet metal panels and may serve a further purpose as a structural "backbone" support member of a UPS cabinet or enclosure 54 (Fig. 4), 110 (Figs. 6-10). The cabinet panels may be configured to form at least a portion of the ductwork. This provides cabinets 54, 110 with increased structural integrity while facilitating the channeling of cooling air. In some embodiments, the panels may further be configured to form a support for mounting the first heat generator 22 thereto.

In smaller systems where there are not as many heat generators that need cooling, ductworks 10, 52, 100 may serve a further purpose of delivering air to transformers (such as second heat generators 124) located proximate the bottom of the cabinet. This may be accomplished with second supply openings 40, 120, which may be opened or closed with a corresponding louver or grate 42, 122 to vent off excess cooling air to supply the transformers. With forced air 46 being supplied to the transformers, the use of smaller transformers may be feasible due to the extra cooling from the air stream. Optimized copper and windings of these smaller transformers may result in additional cost savings. The rest of the cabinets 54, 110 may be designed around this structure, and may be comprised of modular pieces that can be stacked together forming larger cabinets, e.g., single bay, double bay, triple bay, and so on.

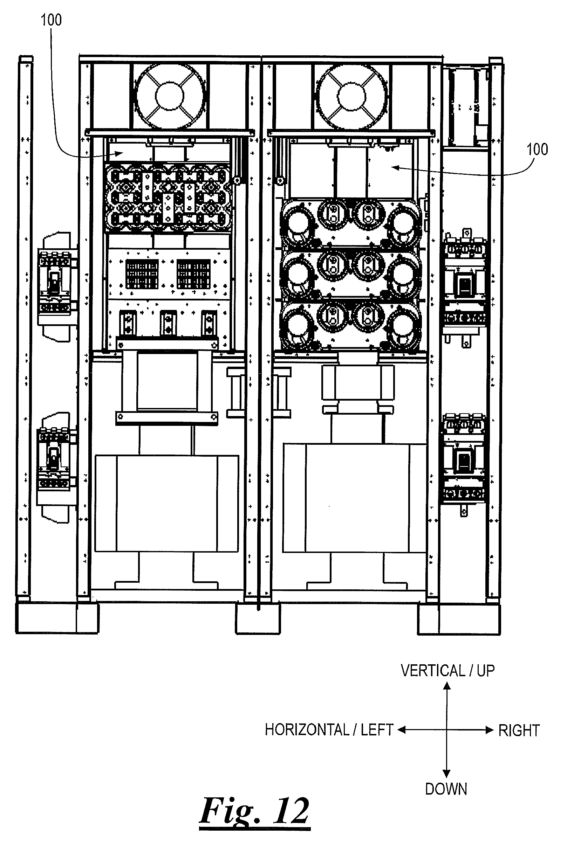

Ductworks 10, 52, 100 may be scalable to accommodate a range of cooling requirements, from relatively low-level heat generators 22 to relatively high-level heat generating devices. In addition, ductworks 10, 52, 100 may be reconfigurable with regard to the aforementioned second supply openings 40, 120 and louvers or grates 42, 122. Accordingly, no matter how physically wide a UPS system configuration is, there only needs to be one ductwork system 10, 52, 100, since the system is modular, and may be configured to supply air for a plurality of heat generators 22. It is also possible to add as many ductworks 10, 100 to additional bays as needed for UPS configurations of various sizes, as shown in Fig. 12.

Ductworks 10, 52, 100 may be further reconfigurable to accommodate various quantities of heat generators 22. For example, ductworks 10, 52, 100 may be configured to accommodate a plurality of fans. The system may use a plurality of supply fans with some fans serving as secondary backups for the primary fans, The fans may be any suitable fan, such as axial fans, but may have other configurations, such as centrifugal.

In some embodiments heat generators 22 may be modules for a UPS, a primary module being an inverter bridge. The inverter module itself is preferably designed to have the minimal base kVA power ratings for the intended load(s). Both single-phase and three-phase inverter configurations are possible with the same module. Each module may then be paralleled to increase the capacity of the UPS system kVA. The modules may also be optimized for manufacture in the same work cell and have a high degree of component commonality, no matter what the base kVA rating of the module is or whether it is single-phase or three-phase.

In one embodiment of the present invention single-phase inverters may comprise two legs (e,g., 2 x dual Insulated-Gate Bipolar Transistor (IGBT) packs). Three-phase inverter may comprise 3 legs (e.g., 3 x dual IGBT Packs). To achieve different base kVA ranges different rotational positions may be used to select DC filter capacitors, which allows for paralleled or series configurations of the DC filter capacitors to obtain higher DC voltages thus higher base capacities. This does, however require two different capacitors with safe working voltages of 200V and 350V respectively. From a mechanical standpoint, the packaging of these capacitors are very similar, so the bus bar, heat sink and structural components remain the same. This design requires less assembly labor and is easy to service. Instead of replacing many different inverter components on a scheduled or unscheduled service visit, a service technician may simply swap out the modules, which may then be reconditioned or refurbished. This simplistic approach works well for inverter modules; however, static switch and charger modules are a bit more complicated.

Typically, static switch and charger components on smaller kVA-rated UPS units produce less heat than on larger units. Therefore, on smaller units, modules may include both charger and static switch on one heatsink, forming one large module. This module, using the same heat sink, can use two different sizes of silicon-controlled rectifiers (SCRs) and much of the busing can remain the same.

With larger kVA-rated UPS units the static switch and charger are split into two distinct modules with differing parts. All modules, however, no matter their function, may be structured and designed around the same standardized heat sink to again leverage savings with volume.

While this invention has been shown and described with respect to several detailed embodiments thereof, it will be understood by those skilled in the art that changes in form and detail thereof may be made without departing from the scope of the claims of the invention. As a non-limiting example, the present invention has been described primarily in connection with cooling electronic components for the sake of illustration. However, the present invention may be utilized to cool any heat-generating objects or devices within the scope of the invention.

## Claims

1. A cooling system, comprising:
a source of pressurized intake air, the source including:
a primary fan,
a secondary fan spaced apart from the primary fan, the pressurized intake air flowing from either of the primary or secondary fans, and
a ductwork, comprising:
an inlet,
at least one generally hollow supply plenum in fluid communication with the inlet, and
at least one supply opening in fluid communication with the supply plenum,
the pressurized intake air being urged into the inlet, through the supply plenum and out of the supply opening as a first air supply,
the supply opening being configured to direct the first air supply toward at least one first heat generator, and
the secondary fan being configured to operate in a predetermined manner corresponding to a status of the primary fan.

2. The cooling system of claim 1 wherein the first air supply is directed toward a plurality of first heat generators.

3. The cooling system of claim 1 wherein the ductwork includes an auxiliary plenum configured to provide a second air supply to at least one second heat generator.

4. The cooling system of claim 3 wherein the auxiliary plenum is coupled to a downstream portion of the supply plenum.

5. The cooling system of claim 3 wherein the second air supply is directed toward a plurality of second heat generators.

6. The cooling system of claim 1 wherein the inlet includes an inlet supply duct configured to receive the primary and secondary fans.

7. The cooling system of claim 1 wherein the first heat generator includes a heat sink adapted to transfer heat away from the first heat generator, the heat being generated by the first heat generator.

8. The cooling system of claim 7 wherein the heat sink is configured to receive the first air supply, the first air supply being bifurcated into a first air portion and a second air portion, the first and second air portions being discharged from opposing sides of the heat sink.

9. The cooling system of claim 1, further including a pressure zone between the primary and secondary fans, the secondary fan being further configured to operate in a predetermined manner corresponding to a status of the pressure zone, the status of the pressure zone being established by the primary fan.

10. The cooling system of claim 9, further wherein the system includes:
a pressure sensor in communication with the pressure zone;
a pressure switch coupled to the pressure sensor; and
a controller coupled to the pressure switch,
the pressure sensor being configured to sense a positive pressure level, a neutral pressure level, and a negative pressure level within the pressure zone, the positive, neutral and negative pressure levels each indicating a predetermined status of the pressure zone, the pressure sensor being further adapted to transmit a pressure signal to the pressure switch corresponding to the status of the pressure zone,
the pressure switch being configured to convert the pressure signal to a corresponding status signal, the status signal indicating the status of the pressure zone as either a normal mode or primary fan failure mode, the pressure switch being configured to transmit the status signal to the controller, and
the controller being configured to receive and process the status signal from the pressure switch and control the operation of the secondary fan in a predetermined manner.

11. The cooling system of claim 10 wherein the negative pressure level corresponds to an operating condition of the primary fan and a normal mode status, the neutral pressure level corresponds to a non-operating condition of the primary fan and a primary fan failure mode status, and the positive pressure level indicates an operating condition of the secondary fan, a non-operating condition of the primary fan and the primary fan failure mode status.

12. The cooling system of claim 11 wherein the controller, upon receiving a status signal from the pressure switch indicating primary fan failure mode status, activates an alarm and the secondary fan.

13. The cooling system of claim 1 wherein the primary and secondary fans are each configured as replaceable modules that are selectably removable from the system.

14. The cooling system of claim 13 wherein the replaceable modules include hot swappable connectors configured to provide electrical power to the primary or secondary fans.

15. A cooling system, comprising:
a cabinet;
a source of pressurized intake air, the source including:
a primary fan,
a secondary fan spaced apart from the primary fan, the pressurized intake air flowing from either of the primary or secondary fans, and
a pressure zone between the primary fan and the secondary fan; and
a ductwork, comprising:
an inlet, the inlet including an inlet supply duct configured to house the primary and secondary fans;
at least one generally hollow supply plenum in fluid communication with the inlet; and
at least one supply opening in fluid communication with the supply plenum,
the pressurized intake air being urged from the inlet through the supply plenum and out of the supply opening as a first air supply,
the supply opening being configured to direct the first air supply toward at least one first heat generator,
the secondary fan being configured to operate in a predetermined manner corresponding to a status of the pressure zone, and
the cabinet being configured to house the source of pressurized intake air, the ductwork, and the first heat generator.

16. The cooling system of claim 15 wherein the cabinet includes a plurality of panels, at least one panel being configured to form at least a portion of the ductwork.

17. The cooling system of claim 16 wherein the at least one panel is further configured to form a support for mounting the first heat generator thereto.

18. The cooling system of claim 15 wherein the cabinet further includes at least one vent, the vent being adapted to allow exhaust air warmed by the first heat generator to be discharged from the cabinet.

19. The cooling system of claim 15 wherein the first heat generator is a power-switching component for an uninterruptable power supply system.

20. A method for cooling heat generators, comprising the steps of:
obtaining a cabinet;
obtaining a source of pressurized intake air, the source including:
a primary fan,
a secondary fan spaced apart from the primary fan, the pressurized intake air flowing from either of the primary or secondary fans, and
a pressure zone between the primary fan and the secondary fan;
obtaining a ductwork, comprising:
an inlet, the inlet including an inlet supply duct configured to house the primary and secondary fans;
at least one generally hollow supply plenum in fluid communication with the inlet, and
at least one supply opening in fluid communication with the supply plenum, and
housing the source of pressurized intake air, the ductwork, and a first heat generator with the cabinet;
urging the pressurized intake air from the inlet through the supply plenum and out of the supply opening as a first air supply,
directing first air supply from the supply opening toward the first heat generator; and
operating the secondary fan in a predetermined manner corresponding to a status of the pressure zone.
